(19) Europäisches Patentamt
European Patent Office
Office européen des brevets

(11) **EP 0 635 936 B1**

(12) **EUROPÄISCHE PATENTSCHRIFT**

(45) Veröffentlichungstag und Bekanntmachung des Hinweises auf die Patenterteilung:
**05.12.2001 Patentblatt 2001/49**

(51) Int Cl.$^7$: **H03G 3/20**, H03G 3/30

(21) Anmeldenummer: **94202110.6**

(22) Anmeldetag: **19.07.1994**

(54) **Übertragungssystem für Zeitmultiplex-Signalübertragung**

Communication system using time-multiplex signals

Système de communication utilisant des signaux selon le système de multiplexage par répartition dans le temps

(84) Benannte Vertragsstaaten:
**DE FR GB IT**

(30) Priorität: **24.07.1993 DE 4324895**

(43) Veröffentlichungstag der Anmeldung:
**25.01.1995 Patentblatt 1995/04**

(73) Patentinhaber:
• **Philips Corporate Intellectual Property GmbH 52064 Aachen (DE)**
Benannte Vertragsstaaten:
**DE**
• **Koninklijke Philips Electronics N.V. 5621 BA Eindhoven (NL)**
Benannte Vertragsstaaten:
**FR GB IT**

(72) Erfinder: **Birth, Winfrid, Dipl.-Ing. Wendenstrasse 35c, D-20097 Hamburg (DE)**

(74) Vertreter: **Volmer, Georg, Dipl.-Ing. et al Philips Corporate Intellectual Property GmbH, Habsburgerallee 11 52064 Aachen (DE)**

(56) Entgegenhaltungen:
**EP-A- 0 462 773        EP-A- 0 524 008**

**Beschreibung**

Die Erfindung bezieht sich auf ein Übertragungssystem für Zeitmultiplex-Signalübertragung gemäß dem Oberbegriff des Patentanspruchs 1. Die Erfindung bezieht sich weiterhin auf einen Sender und eine Schaltungsanordnung gemäß den Oberbegriffen der Patentansprüche 8 und 9.

Ein solches Übertragungssystem ist beispielsweise ein Mobilfunksystem nach dem GSM-Standard. Ein solches System arbeitet im TDMA-Betrieb, d. h. im Zeitmultiplex-Betrieb mit Vielfachzugriff (Time Division Multiple Access).

Aus der europäischen Patentanmeldung 0 462 773 A2 ist ein Regelkreis zur Regelung der Sendeleistung in einem TDMA-System bekannt. Mit Hilfe eines Detektors wird dort über einen Differenzverstärker ein Teil der Sendeleistung auf einen Steuereingang eines Leistungsverstärkers rückgekoppelt. Diese Anordnung regelt den Pegel der Sendeleistung. Ein auf einen anderen Steuereingang des Leistungsverstärkers gegebenes Signal steuert die Form des Ansteigens bzw. Abfallens der Sendeleistung am Anfang und am Ende eines Zeitschlitzes. Bei solchen Schaltungen treten Stabilitätsprobleme auf, wenn hohe Anforderungen bezüglich des Zeitverlaufs der Sendeleistung und des zulässigen Spektralbereichs - wie beispielsweise in den GSM-Spezifikationen - gestellt werden. Weiterhin beeinträchtigen Temperaturabhängigkeiten des Detektors die Funktionsfähigkeit der Schaltung.

Aus der EP 0 524 008 A1 ist auch ein Sender für ein Funkübertragungssystem mit digitaler Modulation bekannt, bei dem die Ausgangsleistung eines Leistungsverstärkers mittels eines Rahmendetektors detektiert wird. Ein Detektorsignal wird in einer Rückkopplungsschleife einem Fehlerverstärker zugeführt, der das Detektorsignal mit einem Standard-Rahmensignal vergleicht. Ein vom Fehlerverstärker erzeugtes Signal wird einem Addierer zugeführt, der eine Addition mit einer Gleichspannung durchführt, mittels der das Spektrum von vom Sender abgegebenen Sendesignalen anpaßbar ist. Der Ausgang des Addierers ist mit dem Steuereingang eines Vorverstärkers verbunden, der ausgangsseitig mit dem Leistungsverstärker verbunden ist.

Der Erfindung liegt daher die Aufgabe zugrunde, ein Zeitmultiplex-Signalübertragungssystem zu schaffen, das leicht stabilisierbar ist und dessen Funktionsfähigkeit durch Temperaturabhängigkeiten des Detektors nicht beeinträchtigt wird. Der Erfindung liegt auch die Aufgabe zugrunde, einen entsprechenden Sender und eine entsprechende Schaltungsanordnung zur Verwirklichung dieses Ziels zu schaffen.

Die Aufgabe wird durch die Merkmale der kennzeichnenden Teile der Ansprüche 1, 8 und 9 gelöst.

Um den Detektor in seinem optimalen Arbeitspunkt betreiben zu können, enthält die Detektorspannung einen Detektorruhespannungsanteil. Am Detektor liegt die Detektorruhespannung an, wenn die Leistung des Ausgangssignals des Leistungsverstärkers einen nicht detektierbaren kleinen Wert besitzt. Die Detektorruhespannung ist temperaturabhängig. Diese Temperaturabhängigkeit wird in der erfindungsgemäßen Anordnung dadurch kompensiert, daß die Steuerspannung aus der Differenz von Detektorspannung und Sollspannung, der die Detektorspannung überlagert ist, gebildet wird. Die Sollspannung bestimmt sowohl die Form als auch den Pegel des zeitlichen Verlaufs der Leistung des Ausgangssignals des Leistungsverstärkers. Die beschriebene Spannungsdifferenz weist keinen Anteil auf, der aus der Detektorruhespannung hervorgeht. Die Rückkopplung des Ausgangs des Leistungsverstärkers auf seinen Steuereingang erfolgt über den Detektor und die Mittel zur Erzeugung der Steuerspannung. Da der Rückkopplungszweig vom Ausgang des Leistungsverstärkers zum Steuereingang kurzgehalten, d. h. mit wenigen phasendrehenden Bauelementen versehen ist, erhält man eine ausreichende Phasenreserve, so daß die Stabilität eines solchen Regelkreises nicht gefährdet ist.

Der integrierende Regler kann als I-Regler oder als PI-Regler mit zusätzlichem Proportional-Anteil ausgeführt werden. Mit Hilfe eines solchen Reglers wird ein Tiefpaß erster Ordnung im Leistungsverstärker kompensiert. Der Regelkreis weist vorteilhaft eine ausreichende Phasenreserve zur Sicherung der Stabilität auf.

In einer Ausgestaltung der Erfindung ist in Reihe zu einer als Detektordiode verwendeten ersten Diode eine zweite Diode mit gleichen Kennwerten geschaltet.

Die im Detektor angeordnete Detektordiode dient zur Gleichrichtung einer gedämpften hochfrequenten Spannung, die aus dem Ausgangssignals des Leistungsverstärkers abgeleitet wird. Auf diese Weise erzeugt sie die Istspannung des Regelkreises. Am Ausgang des Detektors liegt die Detektorspannung an, in die die Durchlaßspannung der Detektordiode, die temperaturabhängig ist oder sich auch durch Fehlerströme ändern kann, eingeht. Um die daraus folgende Temperaturabhängigkeit oder Abhängigkeit von Fehlerströmen der Detektorspannung kompensieren zu können, ist der Detektordiode eine zweite Diode mit gleichen Kennwerten in Reihe geschaltet. Diese wird vom gleichen Gleichstrom wie die Detektordiode durchflossen. Beide Dioden besitzen die gleichen Temperaturabhängigkeiten. Die Spannung der zweiten Diode ist damit gleich der Durchlaßspannung der Detektordiode und wird zur Kompensation der oben genannten Abhängigkeiten der Detektorspannung verwendet.

Die Erfindung wird dadurch weiterhin vorteilhaft ausgestaltet, daß der Anschluß zwischen ersten und zweiter Diode mit dem nicht invertierenden Eingang eines zweiten Operationsverstärker verbunden ist, daß der andere Anschluß der zweiten Diode an einem Gleichspannungspotential liegt, daß der Ausgang des zweiten Operationsverstärkers über die Reihenschaltung eines ersten und eines zweiten Widerstandes mit dem oben genannten Gleichspannungspotential verbunden ist und daß der Anschluß zwischen den beiden Widerständen mit dem invertierenden Eingang des zweiten Operationsverstärkers verbunden ist.

Mit Hilfe des Gleichspannungspotentials ist die Detektorruhespannung leicht zu variieren. Mit der beschriebenen Schaltung wird weiterhin aus der Spannung am Verbindungspunkt zwischen erster und zweiter Diode die Detektorruhespannung abgeleitet, so daß diese am Ausgang des zweiten Operationsverstärkers anliegt und für die oben erwähnte Kompensation von Abhängigkeiten der Detekorspannung von Temperatur und Fehlerströmen verwendet werden, ohne daß der Verbindungspunkt zwischen erster und zweiter Diode belastet wird.

Bei Beginn des Ansteigens der Steuerspannung ist diese gleich einem Startwert ist, der geringfügig unterhalb der Schwellenspannung des Leistungsverstärkers liegt. Die nicht lineare Kennlinie des Leistungsverstärkers weist eine Schwellenspannung auf, die mindestens am Steuereingang anliegen muß, um ein am Eingang des Leistungsverstärkers anliegendes Signal zu verstärken. Befindet sich die Steuerspannung zu Beginn eines Zeitschlitzes bereits auf dem oben beschriebenen Startwert, wird eine zeitliche Verzögerung des Einsetzens der Leistungsverstärkung des Leistungsverstärkers minimiert.

Es ist weiterhin vorteilhaft, daß in einer ersten Phase des Anstiegs der Steuerspannung die Sollspannung gleich einer Vorspannung ist.

Die Vorspannung ermöglicht ein Einschwingen des oben beschriebenen Regelkreises, bevor ein steiler Anstieg der Leistung des Ausgangssignals des Leistungsverstärkers bzw. der Sendeleistung des Senders erfolgt. Die Vorspannung bewirkt, daß Offset-Spannungen eines in Rückkopplungszweig des Regelkreis angeordneten Reglers nicht bewirken können, daß der Regler in negative Spannungsbereiche ausgesteuert wird. Eine solche Aussteuerung würde die Funktionsfähigkeit des Regelkreises verhindern.

Vorteilhaft wird die Erfindung auch dadurch ausgestaltet, daß der erste Operationsverstärker vor einem Ansteigen der Steuerspannung als Subtrahierer mit ungleichen Widerstandsverhältnissen beschaltet ist, dessen beiden Eingängen die Detektorspannung und die mit der Detektorruhespannung überlagerte Sollspannung zugeführt werden.

Auf diese Weise wird mit geringem Schaltungsaufwand am Ausgang des ersten Operationsverstärkers der Startwert der Steuerspannung eingestellt.

In einer anderen Ausgestaltung der Erfindung wird die letzte Phase eines Absenkens der Steuerspannung durch einen negative Sollspannung bestimmt.

Wird am Ende eines Zeitschlitzes zum Absenken der Sendeleistung die Sollspannung auf den Wert Null abgesenkt, so nähert sich die Istspannung und damit die Sendeleistung des Senders dem Wert Null in einem asymptotischen Verlauf. Wird aber in dieser Phase eine negative Sollspannung angelegt, erfolgt das Absenken der Istspannung und damit der Sendeleistung des Senders auf den Wert Null in erheblich kürzerer Zeit.

Weiterhin wird die Erfindung dadurch ausgestaltet, daß der Leistungsverstärker nur einen Eingang zur Aufnahme des hochfrequenten Eingangssignals und der Steuerspannung aufweist.

Die Trennung von hochfrequentem Eingangssignal und Steuerspannung erfolgt bei dieser Ausgestaltung innerhalb des Leistungsverstärkers. Der das hochfrequente Eingangssignal erzeugende Bereich des Senders ist dazu mit Hilfe eines Kondensators gleichspannungsmäßig vom Leistungsverstärker getrennt, um ein Einkoppeln der Steuerspannung in diesen Bereich des Senders zu verhindern.

Ausführungsbeispiele der Erfindung werden nachstehend anhand der Zeichnungen näher erläutert. Es zeigen:

Fig. 1 ein Blockschaltbild eines Leistungsverstärkers mit zugehöriger Regelungsanordnung,
Fig. 2 eine erste Schaltungsanordnung eines Leistungsverstärkers mit zugehöriger Regelungsanordnung,
Fig. 3 eine Steuerungskennlinie des Leistungsverstärkers,
Fig. 4 und 5 ein Übertragungssystem für Zeitmultiplex-Signalübertragung ,
Fig. 6 eine zweite Schaltungsanordnung eines Leistungsverstärkers mit einer zugehörigen Regelungsanordnung,
Fig. 7 Zeitverläufe einer Referenzspannung, einer Sollspannung, einer Istspannung und einer Steuerspannung.

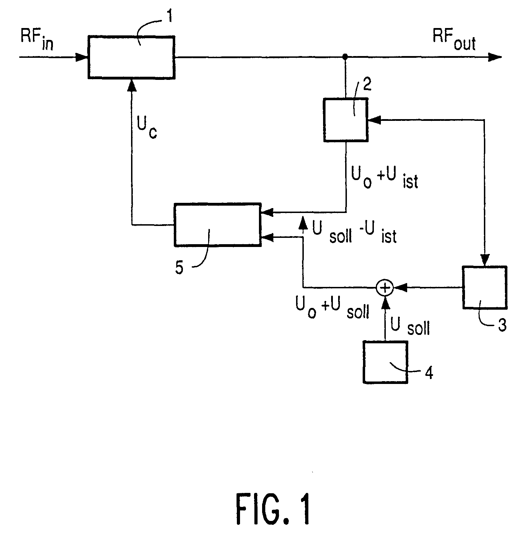

Eine in Fig. 1 dargestellte erfindungsgemäße Anordnung ist beispielsweise Teil eines Senders einer Mobil- oder Basisstation eines digitalen Mobilfunknetzes nach dem GSM-Standard. Die Übertragung von Informationen erfolgt im TDMA-Betrieb. Dazu ist eine Regelung des Ansteigens und Abfallens der Sendeleistung für die jeweiligen Zeitschlitze erforderlich. Ein steuerbarer Leistungsverstärker 1 verstärkt ein hochfrequentes Eingangssignal $RF_{in}$ zu einem hochfrequenten Ausgangssignal $RF_{out}$. Mit Hilfe eines Detektors 2 wird die Leistung des Ausgangssignals $RF_{out}$, d.h. die Sendeleistung des Senders, in eine Detektorspannung umgesetzt, die sich aus der Summe einer Detektorruhespannung $U_0$ und einer Istspannung $U_{ist}$ ergibt. Ein Schaltungsblock 3 ist mit dem Detektor 2 gekoppelt und dient zur Einstellung der Detektorruhespannung $U_0$, die an einem Ausgang des Schaltungsblockes 3 erzeugt wird. Der Schaltungsblock 3 ist in der Lage, Veränderungen des Detektors 2, die beispielsweise durch Temperaturschwankungen bedingt sind, zu erkennen und so weiter zu verarbeiten, daß die Spannung am Ausgang des Schaltungsblockes 3 der tatsächlichen Detektorruhespannung $U_0$ entspricht. Die vom Schaltungsblock 3 erzeugte Spannung $U_0$ wird einer Sollspannung $U_{soll}$ überlagert, die von einem Sollwertgeber 4 geliefert wird. Die mit der Detektorruhespannung $U_0$ überlagerte Sollspannung $U_{soll}$ wird auf einen ersten Eingang eines Steuerspannungsgebers 5 gegeben. An einem zweiten Eingang des Steuerspannungsgebers 5 wird die Detektorspannung $U_0 + U_{ist}$ zugeführt. Ein Ausgang des Steuerspannungsgebers 5, an dem eine Steuerspannung $U_c$ anliegt, ist mit einem Steuereingang des Leistungsverstärkers 1 verbunden.

Mit Hilfe des Detektors 2 wird die Leistung des hochfrequenten Ausgangssignals $RF_{out}$ detektiert und in eine Istspannung $U_{ist}$ umgesetzt. Die Istspannung $U_{ist}$ dient als Regelgröße dieses Regelkreises. Die Sollspannung $U_{soll}$ entspricht einer Führungsgröße. Die daraus folgende Regelabweichung $U_{soll}$ minus $U_{ist}$ bestimmt die als Stellgröße benutzte Steuerspannung $U_c$. Zeitverlauf und Größe der Sollspannung $U_{soll}$ bestimmen somit den Zeitverlauf und den Pegel der Leistung des Ausgangssignals $RF_{out}$ des steuerbaren Leistungsverstärkers 1.

Der Betrieb des Detektors 2 in einem geeigneten Arbeitspunkt setzt voraus, daß der Istspannung $U_{ist}$ eine Detektorruhespannung $U_0$ überlagert ist. Die Detektorruhespannung $U_0$ ergibt sich aus dem Aufbau des Detektors 2 und dem Einfluß des Schaltungsblockes 3. Dieser überlagert der Sollspannung $U_{soll}$ die Detektorruhespannung $U_0$. Die Differenz der an den beiden Eingängen des Steuerspannungsgebers 5 anliegenden beiden Spannungen ist damit gleich ($U_{soll}$-$U_{ist}$). Dies ist die Regelabweichung des Regelkreises, auf die die Detektorruhespannung $U_0$ keinen Einfluß hat. Eine Abhängigkeit der Detektorruhespannung $U_0$ von beispielsweise Temperatur oder Versorgungsspannung wird kompensiert. Außerdem ist mit Hilfe des Schaltungsblockes 3 die Größe der Detektorruhespannung $U_0$ zu beeinflussen, so daß an den beiden Eingängen des Steuerspannungsgebers 5 eine geeignete Gleichtaktspannung anliegt.

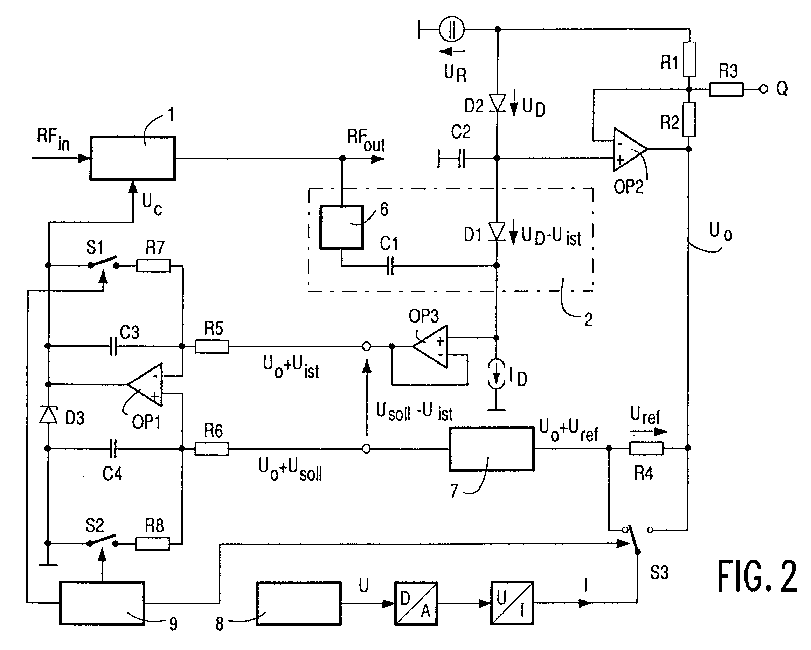

In Fig. 2 wird ein Schaltplan zum in Fig. 1 dargestellten Regelkreis dargestellt. Der Detektor 2 besteht aus einem Dämpfungsglied 6, einem Kondensator C1 und einer Diode D1. Das Dämpfungsglied 6, beispielsweise eine Streifenleitung, erzeugt eine gedämpfte, der Leistung des hochfrequenten Ausgangssignal $RF_{out}$ entsprechende Hochfrequenzspannung, die über den Kondensator C1 der Diode D1 zugeführt und von dieser gleichgerichtet wird. Die Kathode der Diode D1 ist mit dem Kondensator C1 verbunden. Die Anode der Diode D1 ist hochfrequenzmäßig über einen Kondensator C2 mit einem Massepotential kurzgeschlossen. Die an der Diode D1 in Durchlaßrichtung anliegende Spannung ist gleich der Durchlaßspannung $U_D$ abzüglich der Istspannung $U_{ist}$. Die Anode der Diode D1 ist weiterhin mit der Kathode einer Diode D2 verbunden, an deren Anode eine Spannung $U_R$ anliegt.

Die Diode D2 ist von derselben Bauart wie die Diode D1. Zwischen der Anode der Diode D2 und dem Ausgang eines Operationsverstärkers OP2 liegt die Reihenschaltung zweier Widerstände R1 und R2. Diese besitzen näherungsweise den gleichen Widerstandswert. Der invertierende Eingang des Operationsverstärkers OP2 steht in Verbindung mit dem Punkt zwischen R1 und R2, und der nicht invertierende Eingang des Operationsverstärkers OP2 ist mit der Anode der Diode D1 gekoppelt. Der nicht invertierende Eingang des Operationsverstärkers OP2 ist weiterhin über einen Widerstand R3 mit einem Ausgang Q eines Digitalteils des Senders gekoppelt.

Zwischen der Kathode von Diode D1 und dem Massepotential liegt eine Konstantstromquelle, die den Strom $I_D$ liefert. Auf diese Weise wird der Arbeitspunkt der Diode D1 festgelegt. Der Strom $I_D$ ist so bemessen, daß die Diode D1 beim Betrieb des Senders immer leitend ist. Im Ausführungsbeispiel ist $I_D$ zu 60 µA gewählt. Die an der Kathode der Diode D1 anliegende Spannung wird auf den invertierenden Eingang eines als Spannungsfolger beschalteten Operationsverstärkers OP3 gegeben.

Der Ausgang des Operationsverstärkers OP2 ist über einen Widerstand R4 mit dem Eingang eines Tiefpasses 7 vierter Ordnung gekoppelt. Parallel zum Widerstand R4 liegt ein Schalter S3, in dessen linker Stellung ein Strom I über den Widerstand R4 in den Ausgang des Operationsverstärkers OP2 fließt. In der rechten Schalterstellung fließt I direkt in den Ausgang von OP2. Wird der Strom I durch den Widerstand R4 geleitet, fällt am Widerstand R4 eine Referenzspannung $U_{ref}$ ab. Der Strom I wird erzeugt, indem von einer Digitalschaltung 8 eine Steuerspannung U geliefert wird, die über einen Digital-Analog-Wandler und einen Spannung-Strom-Wandler in den Strom I umgewandelt wird.

Der Ausgang des Operationsverstärkers OP3 ist über einen Widerstand R5 mit dem invertierenden Eingang eines Operationsverstärkers OP1 gekoppelt. Der nicht invertierende Eingang von OP1 ist mit einem Anschluß eines Widerstandes R6 verbunden, dessen anderer Anschluß am Ausgang des Tiepasses 7 anliegt. Parallel zur Strecke vom invertierenden Eingang des Operationsverstärkers OP1 bis zu dessen Ausgang liegt einerseits ein Kondensator C3 und andererseits die Reihenschaltung eines Widerstandes R7 mit einem Schalter S1. Der Ausgang von OP1 ist mit der Kathode einer Zehner-Diode D3 verbunden, deren Anode auf Massepotential liegt. Diese dient als Spannungsbegrenzer für die Steuerspannung $U_C$ und stellt eine einfach zu realisierende Schutzschaltung dar. Zwischen der Anode der Zehner-Diode D3 und dem nicht invertierenden Eingang von OP1 ist die Parallelschaltung aus einem Kondensator C4 und der Reihenschaltung eines Widerstandes R8 mit einem Schalter S2 angeordnet. Die Widerstände R5, R6 und R7 besitzen einen gleichen Widerstandswert. Der Widerstand R8 besitzt einen abweichenden Widerstandswert, in diesem Fall einen um 50 % größeren. Die Kapazitätswerte von C3 und C4 sind identisch. Der Ausgang des Operationsverstärkers OP1, an dem die Steuerspannung $U_c$ anliegt, ist mit dem Steuereingang des Leistungsverstärkers 1 verbunden.

Der Konstantstrom $I_D$, der durch die beiden Dioden D1 und D2 fließt, bewirkt, daß sich beide Dioden immer im leitenden Zustand befinden. Mit $I_D$ läßt sich ein geeigneter Arbeitspunkt von D1 und D2 einstellen. Ist die Leistung des Ausgangssignals $RF_{out}$ gleich Null, so fällt an der Diode D1 nur die Durchlaßspannung $U_D$ ab. $U_D$ liegt auch an der Diode D2 an. Der Detektor 2 liefert in diesem Fall seine Detektorruhespannung $U_o$, die sich zu

$$U_0 = U_R - 2\,U_D$$

berechnet. Die Detektorruhespannung ist durch $U_R$ leicht einstellbar. Die Detektorruhespannung liegt weiterhin am Ausgang des Operationsverstärkers OP2 an. In einer solchen Sendepause, bei der die Leistung des Ausgangssignals $RF_{out}$ gleich Null ist, befindet sich S3 in der rechten Schalterstellung. Der Strom I fließt damit direkt in den Ausgang des Operationsverstärkers OP2 und bewirkt keinen Spannungsabfall am Widerstand R4. Daraus ergibt sich, daß am Ausgang des Tiefpasses 7 die Detektorruhespannung $U_o$ anliegt. $U_o$ liegt wie eben beschrieben auch am Detektorausgang und damit am Ausgang des als Spannungsfolger beschalteten Operationsverstärkers OP3 an. In einer Sendepause sind die Schalter S1 und S2 geschlossen. Die Kondensatoren C3 und C4 sind in diesem Zustand schaltungstechnisch nicht relevant.

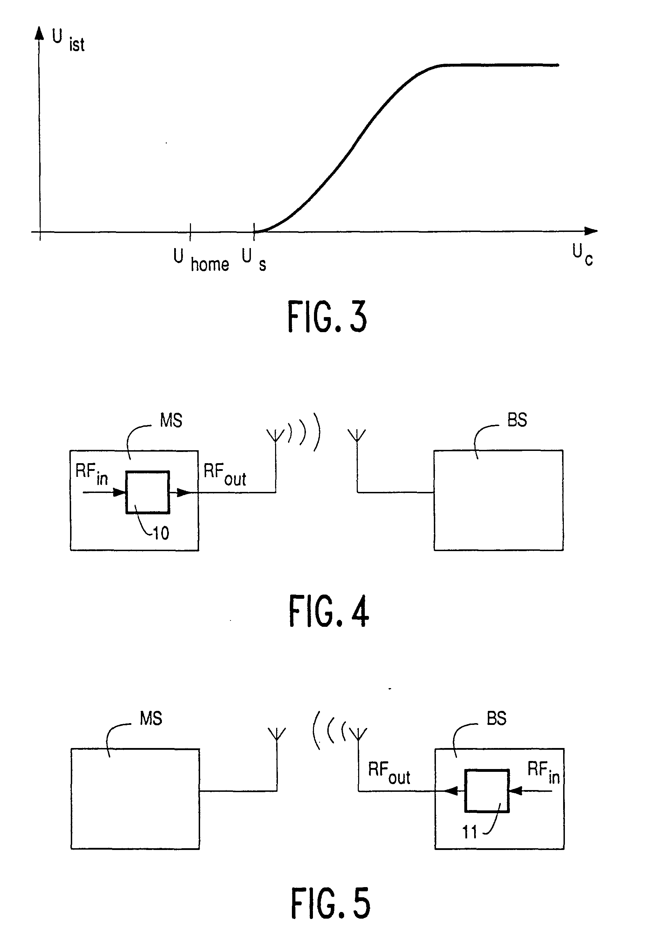

Der Schaltungsteil mit dem Operationsverstärker OP1 und dem Widerständen R5, R6, R7 und R8 wirkt als Subtrahierer, dessen zwei Eingänge mit den Ausgängen des Operationsverstärkers OP3 und des Tiefpasses 7 verbunden sind. Der Ausgang von OP1 stellt den Ausgang dieses Subtrahierers dar. Da R8 einen von R5, R6 und R7 abweichenden Widerstandswert besitzt, stellt sich aufgrund dieser Unsymmetrie am Ausgang von OP1 eine von Null verschiedene Spannung ein, trotzdem an den Eingängen des beschriebenen Subtrahierers in beiden Fällen die Detektorruhespannung $U_0$ anliegt. Diese Ausgangsspannung von OP1 ist gleich einem Startwert der $U_{home}$ der Steuerspannung $U_c$. Dieser Startwert $U_{home}$ liegt geringfügig unterhalb einer Schwellenspannung $U_s$ des Leistungsverstärkers 1, wie aus Fig. 3 deutlich wird. Überschreitet die Steuerspannung $U_c$ die Schwellenspannung $U_s$, beginnt der Leistungsverstärker 1 zu verstärken, so daß an der Diode D1 des Detektors 2 eine Istspannung $U_{ist}$ detektierbar ist.

Ein Sendevorgang wird eingeleitet, indem eine im Sender angeordnete Digitalschaltung 9 die Schalter S1 und S2 öffnet und den Schalter S3 in die linke Position umschaltet. Der Strom I fließt nun durch den Widerstand R4 und bewirkt an diesem einen Spannungsabfall $U_{ref}$. Am Eingang des Tiefpasses 7 liegt somit die Summe aus $U_0$ und $U_{ref}$ an. Der Ausgang des Tiefpasses 5 liefert jetzt die Summe aus der Detektorruhespannung $U_0$ und der Sollspannung $U_{soll}$. $U_{soll}$ entspricht der vom Tiefpaß 7 gefilterten Spannung $U_{ref}$, die einen rechteckförmigen Verlauf besitzt. Der zeitliche Verlauf der Sollspannung $U_{soll}$ wird durch die Filtereigenschaften des Tiefpaßfilters 7 bestimmt. Die Größe von $U_{soll}$ leitet sich aus dem Widerstandswert von R4 und dem Strom I ab, und damit aus der Digitalschaltung 8 gelieferten Spannung U. Durch das Öffnen der Schalter S1 und S2 ist der Operationsverstärker OP1 nun als Integralregler geschaltet. Seine Zeitkonstante ergibt sich zu

$$T = R5\,C3$$

Der Kondensator C4 ist aus schaltungstechnischen Symmetriegründen vorgesehen. Die Spannung am Ausgang des Operationsverstärkers OP1 steigt an, da sich durch Erhöhen der Sollspannung $U_{soll}$ eine Spannungsdifferenz an seinen Eingängen und damit an den Eingängen des Integralreglers ergibt. Das hieraus folgende Ansteigen der Steuerspannung $U_c$ bewirkt ein Erhöhen des Verstärkungsfaktors des Leistungsverstärkers 1, so daß die Leistung des Ausgangssignals $RF_{out}$ ansteigt. Die Diode D1 des Detektors 2 detektiert die Leistung des hochfrequenten Ausgangssignals $RF_{out}$ und wandelt diese in eine Istspannung $U_{ist}$ um. An der Diode D1 liegt nun in Durchlaßrichtung die Durchlaßspannung $U_D$ abzüglich der Istspannung $U_{ist}$ an. Die Spannung am Ausgang des Operationsverstärkers OP3 erhöht sich auf den Wert $U_0$ plus $U_{ist}$. An den beiden Eingängen des Integralreglers liegt somit die Differenz aus $U_{soll}$ und $U_{ist}$ an. Der Integralregler sorgt dafür, daß die Istspannung $U_{ist}$ der Sollspannung $U_{soll}$ nachgeführt wird.

Zum Absenken der Leistung des Ausgangssignals $RF_{out}$ des Leistungsverstärkers 1 und damit der Sendeleistung nach dem Senden der zu übertragenden Daten eines Zeitschlitzes wird der Schalter S3 in die rechte Stellung umgeschaltet, so daß $U_{ref}$ zu Null wird. Um das Absenken der Sendeleistung zu beschleunigen, wird beim Einsatz des Senders in Mobilstationen am Anschluß Q eine positive Spannung wie beispielsweise die eine Versorgungsspannung angelegt, was ein Absinken der Spannung am Ausgang von OP2 unter die Detektorruhespannung $U_0$ bewirkt. Dies wirkt sich in der Schaltung wie eine negative Sollspannung $U_{soll}$ aus, so daß die Istspannung $U_{ist}$ und damit die Sendeleistung in kürzerer Zeit auf den Wert Null abfallen. Hierbei fällt die Steuerspannung $U_c$ unter den Startwert $U_{home}$ ab. Nach dem Schließen der Schalter S1 und S2 wird dieser Startwert $U_{home}$ wieder aufgebaut. Dieses Verfahren wird insbesondere in Mobilstationen verwendet, wo genügend Zeit für das erneute Aufbauen des Startwertes $U_{home}$ zwischen zwei Zeitschlitzen zur Verfügung steht.

Der Rückkopplungspfad vom Ausgang des Leistungsverstärkers 1 über den Detektor 2, den als Spannungsfolger beschalteten Operationsverstärker OP3 und den Integralregler, dessen Ausgang mit dem Steuereingang des Leistungsverstärkers 1 gekoppelt ist, ist in dieser Schaltung kurz gehalten, d. h. mit einer möglichst geringen Zahl an phasendrehenden Bauelementen versehen. Auf diese Weise ergibt sich eine große Phasenreserve des Regelkreises, so daß die Gefahr einer Instabilität verringert wird. Die am Eingang des Integralreglers anliegende Gleichtaktspannung ist mit Hilfe der Spannung $U_R$ leicht einstellbar. Mit einfachsten Mitteln kann auf diese Weise der zulässige Gleichttaktspannungsbereich des Operationsverstärkers OP1 des Integralreglers eingehalten werden. Da die Detektorruhespannung $U_0$ auf die Spannungsdifferenz bei den Eingängen des Integralreglers keinen Einfluß ausübt, sind Temperatureinflüsse auf die Diode D1 des Detektors 2 ohne Bedeutung.

Die in Fig. 3 dargestellte Kennlinie erläutert das nicht lineare Verhalten des Leistungsverstärkers 1. Es ist die Istspannung $U_{ist}$ über der Steuerspannung $U_c$ dargestellt. Es wird ersichtlich, daß die Istspannung $U_{ist}$ erst für Steuerspannungen, die größer als eine Schwellenspannung $U_s$ sind, Werte größer als Null annimmt. Es ist beispielhaft ein Startwert $U_{home}$ der Steuerspannung $U_c$ eingezeichnet, der wie in Fig. 2 beschrieben erzeugt wird. Beim Einleiten eines Sendevorgangs muß die Steuerspannung $U_c$, die am Ausgang des Integralreglers anliegt, nur um den Differenzbetrag von der Schwellenspannung $U_s$ und des Startwertes $U_{home}$ erhöht werden. Auf diese Weise wird die Einschaltverzögerung des Senders mit dem geregelten Leistungsverstärkers 1 minimiert.

Die Figuren 4 und 5 zeigen ein Übertragungssystem für Zeitmultiplex-Signalübertragung. Es ist ein Mobilfunksystem dargestellt, das eine Basisfunktion BS und eine Mobilstation MS enthält. Diese enthalten einen steuerbaren Leistungsverstärker mit Regelungsschaltung 10, 11, wie sie in den Figuren 1, 2 oder 6 dargestellt ist. In Fig. 4 befindet sich die Mobilstation MS, in Fig. 5 die Basisstation BS im Sendebetrieb.

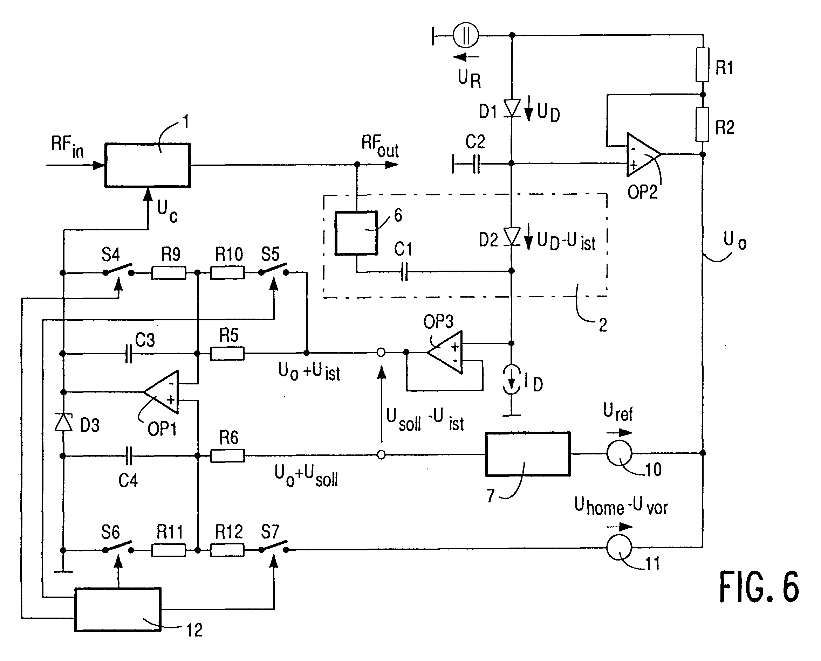

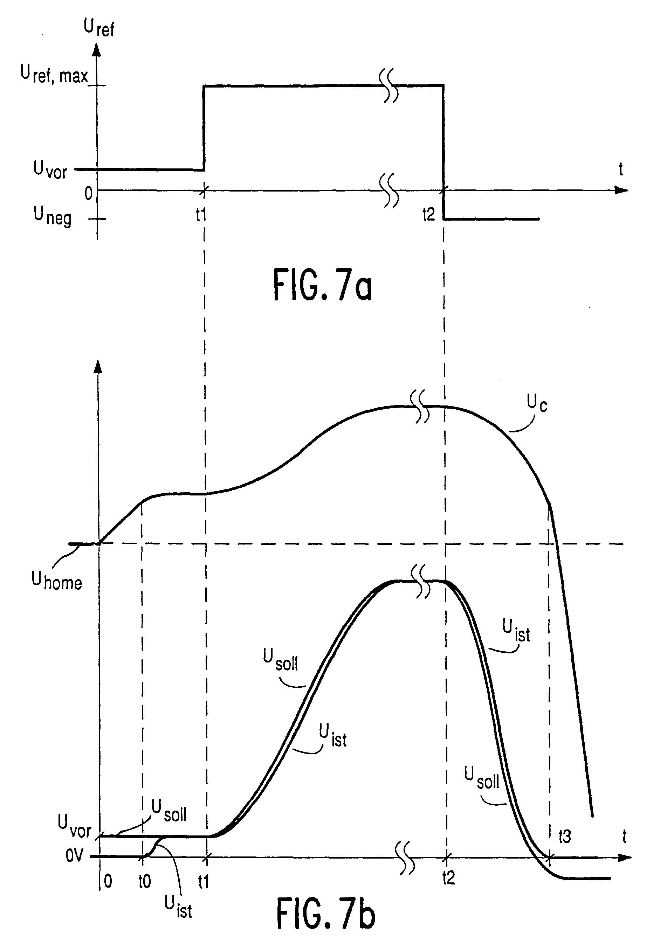

Fig. 6 zeigt einen steuerbaren Leistungsverstärker 1 mit einer modifizierten Regelungsanordnung. Gegenüber Fig. 2 liegen folgende Änderungen vor: Zwischen dem Ausgang des Operationsverstärkers OP2 und dem Eingang des Tiefpasses 7 ist eine Spannungsquelle 10 angeordnet, die die Spannung $U_{ref}$ liefert. Der zeitliche Verlauf dieser Spannung $U_{ref}$ ist in Fig. 7a dargestellt. Zwischen dem Ausgang von OP2 und dem nicht invertierenden Eingang des Operationsverstärkers OP1 liegt die Reihenschaltung einer Spannungsquelle 11, eines Schalters S7 und eines Widerstandes R12. Der Integralregler, der aus den Bauelementen OP1, C3, C4, R5 und R6 besteht, ist unverändert gegenüber Fig. 2. Parallel zum Kondensator C3 liegt nun die Reihenschaltung eines Schalters S4 und eines Widerstandes R9. Parallel zum Widerstand R5 ist die Reihenschaltung eines Widerstandes R9 und eines Schalters S5 geschaltet. Parallel zum Kondensator C4 liegt die Reihenschaltung eines Widerstandes R11 und eines Schalters S6. R5, R6, R9, R10, R11 und R12 besitzen alle den gleichen Widerstandswert. Die Schalter S4, S5, S6 und S7 werden durch einen Schaltungsblock 12 gesteuert, der sich im Digitalteil des Senders befindet. In einer Sendepause, in der die Leistung des Ausgangssignal $RF_{out}$ und damit auch die Istspannung $U_{ist}$ gleich Null sind, liefert die Spannungsquelle 10 eine Spannung $U_{ref}$, die gleich der Vorspannung $U_{vor}$ ist. Der bei geschlossenen Schalter S4 bis S7 als Subtrahierer beschaltete Operationsverstärker OP1 liefert somit während einer Sendepause den Startwert $U_{home}$. Ein Sendevorgang wird eingeleitet, indem der Schaltungsblock 12 die Schalter S4 bis S7 öffnet. Die Widerstände R9 bis R12 und die Spannungsquelle 11 haben nun keine Wirkung mehr. OP1 arbeitet zusammen mit C3, R5, C4 und R6 wie schon in Fig. 2 beschrieben als Integralregler.

In Fig. 7 sind Zeitverläufe der Spannung $U_{ref}$ nach Fig. 6, der Steuerspannung $U_c$, der Sollspannung $U_{soll}$ und der Istspannung $U_{ist}$ skizziert. Für Zeitpunkte t<0, die in einer Sendepause liegen, ist die Spannung $U_{ref}$ gleich der Vorspannung $U_{vor}$. Die Steuerspannung $U_c$ ist für diese Zeitpunkte gleich einem Startwert $U_{home}$. $U_{ref}$ bleibt auf dem Wert der Vorspannung $U_{vor}$ bis zum Zeitpunkt t1. Zum Zeitpunkt t=0 beginnt die Einschwingphase des Integralreglers. Dies zeigt sich durch ein Ansteigen der Steuerspannung $U_c$ bis zum Zeitpunkt t0. Zum Zeitpunkt t0 beginnt die Istspannung $U_{ist}$ anzusteigen, bis sie die Sollspannung $U_{soll}$ bzw. die Vorspannung $U_{vor}$ erreicht hat. Von diesem Zeitpunkt an bis zum Zeitpunkt t1 bleibt die Steuerspannung $U_c$ konstant. Der Integralregler ist eingeschwungen. Zum Zeitpunkt t1 beginnt das eigentliche Anheben der Leistung des Ausgangssignal $RF_{out}$ auf den Wert, mit dem zu übertragene digitale Daten gesendet werden. Dazu wird die Spannung $U_{ref}$ auf den Wert $U_{ref, max}$ angehoben. Durch Filterung mit Hilfe des Tiefpasses 7 wird die steile Flanke von $U_{ref}$ in eine langsamer ansteigende abgerundete Flanke der Sollspannung $U_{soll}$ umgesetzt. Die Istspannung $U_{ist}$ wird der Sollspannung $U_{soll}$ nachgeführt. Haben beide Spannungen ihren Maximalwert erreicht, kann eine Übertragung von Daten erfolgen. Die Zeitachse wurde unterbrochen, da der Sendezeitraum, der für eine Datenübertragung zur Verfügung steht, aufgrund seiner Länge in der Zeichnung nicht maßstäblich darstellbar ist. Zum Zeitpunkt t2 ist die Übertragung von Daten abgeschlossen. Nun wird $U_{ref}$ auf die negative Spannung $U_{neg}$ gesenkt. Dies bewirkt ein Abfallen der Sollspannung $U_{soll}$, ein Abfallen der Istspannung $U_{ist}$ und damit ein Abfallen der Steuerspannung $U_c$. Zum Zeitpunkt t3 hat die Istspannung $U_{ist}$ den Wert Null erreicht. Dies bewirkt ein verstärktes Absenken der Steuerspannung $U_c$. Bis zu einem späteren Zeitpunkt innerhalb der jetzt vorliegenden Sendepause die Schalter S4 bis S7 aus Fig. 4 wieder geschlossen werden, steigt der Wert der Steuerspannung $U_c$ wieder auf ihren Startwert $U_{home}$ an.

Mit Hilfe der angegebenen Schaltungen läßt sich der Zeitverlauf der Sendeleistung so regeln, daß die für digitale Mobiltelephone nach dem GSM-Standard und deren zugehörige Basisstationen vorgegebenen Zeitmasken und Frequenzspektren eingehalten werden.

**Patentansprüche**

1. Übertragungssystem für Zeitmultiplex-Signalübertragung mit mindestens einem Sender mit

   - einem Leistungsverstärker (1), der einen zum Empfang einer Steuerspannung ($U_c$) vorgesehenen Steuereingang aufweist, zur Verstärkung eines hochfrequenten Eingangssignals ($RF_{in}$) zu einem hochfrequenten Ausgangssignal ($RF_{out}$),
   - einem zur Lieferung einer Detektorspannung ($U_0 + U_{ist}$) vorgesehenen Detektor (2) zum Detektieren der Leistung des Ausgangssignals ($RF_{out}$) und zur Erzeugung einer Detektorspannung ($U_0 + U_{ist}$), die durch Überlagerung einer Detektorruhespannung ($U_0$) mit einer Istspannung ($U_{ist}$) gebildet wird,
   - Mitteln (4) zur Erzeugung einer Sollspannung ($U_{soll}$), die den Zeitverlauf der Leistung des Ausgangssignals ($RF_{out}$) bestimmen,

   **gekennzeichnet durch** einen Schaltungsteil (5) zur Erzeugung der Steuerspannung ($U_c$) aus der Differenz von Sollspannung ($U_{soll}$) und Istspannung ($U_{ist}$) mit einem beschalteten Operationsverstärker (OP1) und mit die Beschaltung des Operationsverstärkers bestimmenden steuerbaren Schaltelementen (S1, S2; S4, S5, S6, S7), wobei in einem der Schaltzustände der Schaltelemente (S1, S2; S4, S5, S6, S7) während eines Sendevorgangs der Operationsverstärker (OP1) so beschaltet ist, daß der Schaltungsteil (5) als integrierender Regler wirkt und wobei in einem anderen Schaltzustand der Schaltelemente (S1, S2; S4, S5, S6, S7) der Operationsverstärker (OP1) so beschaltet ist, daß der Schaltungsteil (5) als Subtrahierverstärker wirkt, so daß am Ende einer Sendepause (t=0) ein Startwert ($U_{home}$) der Steuerspannung ($U_c$) erzeugt wird, der geringfügig unterhalb der Schwellenspannung ($U_s$) des Leistungsverstärkers (1) liegt.

2. Übertragungssystem nach Anspruch 1,
   **dadurch gekennzeichnet,**
   **daß** in Reihe zu einer als Detektordiode verwendeten ersten Diode (D1) eine zweite Diode (D2) mit gleichen Kennwerten geschaltet ist.

3. Übertragungssystem nach Anspruch 2,
   **dadurch gekennzeichnet,**

   **daß** der Anschluß zwischen erster und zweiter Diode (D1, D2) mit dem nicht invertierenden Eingang eines zweiten Operationsverstärkers (OP2) verbunden ist,
   **daß** der andere Anschluß der zweiten Diode (D2) an einem Gleichspannungspotential ($U_R$) liegt,
   **daß** der Ausgang des zweiten Operationsverstärkers (OP2) über die Reihenschaltung eines ersten und eines zweiten Widerstandes (R1, R2) mit dem oben genannten Gleichspannungspotential ($U_R$) verbunden ist und
   **daß** der Anschluß zwischen den beiden Widerständen mit dem invertierenden Eingang des zweiten Operationsverstärkers (OP2) verbunden ist.

4. Übertragungssystem nach einem der Ansprüche 1 bis 3,
   **dadurch gekennzeichnet,**
   **daß** in einer ersten Phase des Anstiegs der Steuerspannung ($U_c$) die Sollspannung ($U_{soll}$) gleich einer Vorspannung ($U_{vor}$) ist.

5. Übertragungssystem nach Anspruch 4,
   **dadurch gekennzeichnet,**
   **daß** die letzte Phase eines Absenkens der Steuerspannung ($U_c$) durch eine negative Sollspannung ($U_{neg}$) bestimmt wird.

6. Übertragungssystem nach Anspruch 4 oder 5,
   **dadurch gekennzeichnet,**
   **daß** nach der ersten Phase des Anstiegs der Steuerspannung ($U_c$) die Sollspannung ($U_{soll}$) rampenförmig ansteigt, sich danach ein Zeitraum mit konstanter Sollspannung ($U_{soll}$) anschließt und darauf die Sollspannung rampenförmig abfällt.

7. Übertragungssystem nach einem der Ansprüche 1 bis 6,
   dadurch ekennzeichnet,
   daß der Leistungsverstärker (1) nur einen Eingang zur Aufnahme des hochfrequenten Eingangssignals ($RF_{in}$) und der Steuerspannung ($U_c$) aufweist.

8. Sender für Zeitmultiplex-Signalübertragung mit

   - einem Leistungsverstärker (1), der einen zum Empfang einer Steuerspannung ($U_c$) vorgesehenen Steuereingang aufweist, zur Verstärkung eines hochfrequenten Eingangssignals ($RF_{in}$) zu einem hochfrequenten Ausgangssignal ($RF_{out}$),
   - einem zur Lieferung einer Detektorspannung ($U_0 + U_{ist}$) vorgesehenen Detektor (2) zum Detektieren der Leistung des Ausgangssignals ($RF_{out}$) und zur Erzeugung einer Detektorspannung ($U_0 + U_{ist}$), die durch Überlagerung einer Detektorruhespannung ($U_0$) mit einer Istspannung ($U_{ist}$) gebildet wird,

- Mitteln (4) zur Erzeugung einer Sollspannung ($U_{soll}$), die den Zeitverlauf der Leistung des Ausgangssignals ($RF_{out}$) bestimmen,

**gekennzeichnet durch**

einen Schaltungsteil (5) zur Erzeugung der Steuerspannung ($U_c$) aus der Differenz von Sollspannung ($U_{soll}$) und Istspannung ($U_{ist}$) mit einem beschalteten Operationsverstärker (OP1) und mit die Beschaltung des Operationsverstärkers bestimmenden steuerbaren Schaltelementen (S1, S2; S4, S5, S6, S7), wobei in einem der Schaltzustände der Schaltelemente (S1, S2; S4, S5, S6, S7) während eines Sendevorgangs der Operationsverstärker (OP1) so beschaltet ist, daß der Schaltungsteil (5) als integrierender Regler wirkt und wobei in einem anderen Schaltzustand der Schaltelemente (S1, S2; S4, S5, S6, S7) der Operationsverstärker (OP1) so beschaltet ist, daß der Schaltungsteil (5) als Subtrahierverstärker wirkt, so daß am Ende einer Sendepause (t=0) ein Startwert ($U_{home}$) der Steuerspannung ($U_c$) erzeugt wird, der geringfügig unterhalb der Schwellenspannung ($U_s$) des Leistungsverstärkers (1) liegt.

9. Schaltungsanordnung für einen Sender mit Zeitmultiplex-Signalübertragung mit

- einem Leistungsverstärker (1), der einen zum Empfang einer Steuerspannung ($U_c$) vorgesehenen Steuereingang aufweist, zur Verstärkung eines hochfrequenten Eingangssignals ($RF_{in}$) zu einem hochfrequenten Ausgangssignal ($RF_{out}$),
- einem zur Lieferung einer Detektorspannung ($U_0 + U_{ist}$) vorgesehenen Detektor (2) zum Detektieren der Leistung des Ausgangssignals ($RF_{out}$) und zur Erzeugung einer Detektorspannung ($U_0 + U_{ist}$), die durch Überlagerung einer Detektorruhespannung ($U_0$) mit einer Istspannung ($U_{ist}$) gebildet wird,
- Mitteln (4) zur Erzeugung einer Sollspannung ($U_{soll}$), die den Zeitverlauf der Leistung des Ausgangssignals ($RF_{out}$) bestimmen,

**gekennzeichnet durch**

einen Schaltungsteil (5) zur Erzeugung der Steuerspannung ($U_c$) aus der Differenz von Sollspannung ($U_{soll}$) und Istspannung ($U_{ist}$) mit einem beschalteten Operationsverstärker (OP1) und mit die Beschaltung des Operationsverstärkers bestimmenden steuerbaren Schaltelementen (S1, S2; S4, S5, S6, S7), wobei in einem der Schaltzustände der Schaltelemente (S1, S2; S4, S5, S6, S7) während eines Sendevorgangs der Operationsverstärker (OP1) so beschaltet ist, daß der Schaltungsteil (5) als integrierender Regler wirkt und wobei in einem anderen Schaltzustand der Schaltelemente (S1, S2; S4, S5, S6, S7) der Operationsverstärker (OP1) so beschaltet ist, daß der Schaltungsteil (5) als Subtrahierverstärker wirkt, so daß am Ende einer Sendepause (t=0) ein Startwert ($U_{home}$) der Steuerspannung ($U_c$) erzeugt wird, der geringfügig unterhalb der Schwellenspannung ($U_s$) des Leistungsverstärkers (1) liegt.

**Claims**

1. A transmission system for time-division multiplex signal transmission, comprising at least a transmitter which includes

 - a power amplifier (1) having a control input supplied with a control voltage ($U_c$), for amplifying a high-frequency input signal ($RF_{in}$) to a high-frequency output signal ($RF_{out}$),
 - a detector (2) supplying a detector voltage ($U_0 + U_{ist}$) for detecting the power of the output signal ($RF_{out}$) and for generating a detector voltage ($U_0 + U_{ist}$) which is formed by superimposing a detected quiescent voltage ($U_0$) with an actual voltage ($U_{ist}$),
 - means (4) for generating a nominal voltage ($U_{soll}$), which determine the waveform of the power of the output signal ($RF_{out}$),

 **characterized**

 **by** a circuit portion (5) for generating the control voltage ($U_c$) from the difference between nominal voltage ($U_{soll}$) and actual voltage ($U_{ist}$) by means of a connected operational amplifier (OP1) and controllable switch elements (S1, S2, S4, S5, S6, S7) determining the connection of the operational amplifier, while in one of the switching states of the switch elements (S1, S2, S4, S5, S6, S7) during a transmission the operational amplifier (OP1) is connected such that the circuit portion (5) works as an integrated controller and in another state of the switch elements (S1, S2, S4, S5, S6, S7) the operational amplifier (OP1) is connected such that the circuit portion (5) works as a subtracter amplifier, so that at the end of a transmit pause (t=0) a start value ($U_{home}$) of the control voltage ($U_c$) is generated that is slightly below the threshold voltage ($U_s$) of the power amplifier (1).

2. A transmission system as claimed in Claim 1, **characterized** **in that** a second diode (D2) is connected in series with a first diode (D1) used as a detector diode, which diodes have the same parameters.

3. A transmission system as claimed in Claim 2, **characterized in that** the lead between the first and the second diode (D1, D2) is connected to the noninverting input of a second operational amplifier (OP2),

    **in that** the other lead of the second diode (D2) is connected to a DC voltage potential ($U_R$), **in that** the output of the second operational amplifier (OP2) is connected to said DC voltage potential ($U_R$) *via* the series combination of a first and a second resistor (R1, R2), and **in that** the node between the two resistors is connected to the inverting input of the second operational amplifier (OP2).

4. A transmission system as claimed in one of the Claims 1 to 3, **characterized in that** in a first phase of the rise of the control voltage ($U_c$), the nominal voltage ($U_{soll}$) is equal to a bias voltage ($U_{vor}$).

5. A transmission system as claimed in Claim 4, **characterized in that** the last phase of a drop of the control voltage ($U_c$) is determined by a negative nominal voltage ($U_{neg}$).

6. A transmission system as claimed in one of the Claims 4 or 5, **characterized in that** after the first phase of the rise of the control voltage ($U_c$), the nominal voltage ($U_{soll}$) rises in the form of a ramp, then follows a constant nominal voltage ($U_{soll}$) for a period of time and then the nominal voltage drops in the form of a ramp.

7. A transmission system as claimed in one of the Claims 1 to 6, **characterized in that** the power amplifier (1) has only one input for receiving the high-frequency input signal ($Rf_{in}$) and the control voltage ($U_c$).

8. A transmitter for time-division multiplex signal transmission, including

    - a power amplifier (1) having a control input supplied with a control voltage ($U_c$), for amplifying a high-frequency input signal ($RF_{in}$) to a high-frequency output signal ($RF_{out}$),
    - a detector (2) supplying a detector voltage ($U_o + U_{ist}$) for detecting the power of the output signal ($RF_{out}$) and for generating a detector voltage ($U_o + U_{ist}$) which is formed by superimposing a detected quiescent voltage ($U_o$) with an actual voltage ($U_{ist}$),
    - means (4) for generating a nominal voltage ($U_{soll}$), which determine the waveform of the power of the output signal ($RF_{out}$),

    **characterized by** a circuit portion (5) for generating the control voltage ($U_c$) from the difference between nominal voltage ($U_{soll}$) and actual voltage ($U_{ist}$) by means of a connected operational amplifier (OP1) and controllable switch elements (S1, S2, S4, S5, S6, S7) determining the connection of the operational amplifier, while in one of the switching states of the switch elements (S1, S2, S4, S5, S6, S7) during a transmission the operational amplifier (OP1) is connected such that the circuit portion (5) works as an integrated controller and in another state of the switch elements (S1, S2, S4, S5, S6, S7) the operational amplifier (OP1) is connected such that the circuit portion (5) works as a subtracter amplifier, so that at the end of a transmit pause (t=0) a start value ($U_{home}$) of the control voltage ($U_c$) is generated that is slightly below the threshold voltage ($U_s$) of the power amplifier (1).

9. A circuit arrangement for a transmitter for time-division multiplex signal transmission, including

    - a power amplifier (1) having a control input supplied with a control voltage ($U_c$), for amplifying a high-frequency input signal ($RF_{in}$) to a high-frequency output signal ($RF_{out}$),
    - a detector (2) supplying a detector voltage ($U_o + U_{ist}$) for detecting the power of the output signal ($RF_{out}$) and for generating a detector voltage ($U_o + U_{ist}$) which is formed by superimposing a detected quiescent voltage ($U_o$) with an actual voltage ($U_{ist}$),
    - means (4) for generating a nominal voltage ($U_{soll}$), which determine the waveform of the power of the output signal ($RF_{out}$),

    **characterized by** a circuit portion (5) for generating the control voltage ($U_c$) from the difference between nominal voltage ($U_{soll}$) and actual voltage ($U_{ist}$) by means of a connected operational amplifier (OP1) and controllable switch elements (S1, S2, S4, S5, S6, S7) determining the connection of the operational amplifier, while in one of the switching states of the switch elements (S1, S2, S4, S5, S6, S7) during a transmission the operational amplifier (OP1) is connected such that the circuit portion (5) works as an integrated controller and in another state of the switch elements (S1, S2, S4, S5, S6, S7) the operational amplifier (OP1) is connected such that the circuit portion (5) works as a subtracter amplifier, so that at the end of a transmit pause (t=0) a start value ($U_{home}$) of the control voltage ($U_c$) is generated that is slightly below the threshold voltage ($U_s$) of the power amplifier (1).

**Revendications**

1.  Système de communication utilisant des signaux selon le système de multiplexage par répartition dans le temps avec au moins un émetteur avec :

    -   un amplificateur de puissance (1) qui présente une entrée de commande prévue pour la réception d'une tension de commande ($U_c$), en vue de l'amplification d'un signal d'entrée à haute fréquence ($RF_{in}$) vers un signal de sortie ($RF_{out}$) à haute fréquence,
    -   un détecteur (2) prévu en vue de la délivrance d'une tension de détecteur ($U_0 + U_{réelle}$) pour la détection de la puissance du signal de sortie ($RF_{out}$) et pour la production d'une tension de détecteur ($U_0 + U_{réelle}$) qui est formée par la superposition d'une tension de repos de détecteur ($U_0$) avec une tension réelle ($U_{réelle}$),
    -   des moyens (4) en vue de la production d'une tension de consigne ($U_{consigne}$) qui déterminent le tracé temporel de la puissance du signal de sortie ($RF_{out}$),

    **caractérisé par**
    une partie de circuit (5) en vue de la production de la tension de commande ($U_c$) à partir de la différence de la tension de consigne ($U_{consigne}$) et de la tension réelle ($U_{réelle}$) avec un amplificateur d'opération monté (OP1) et avec les éléments de commutation (S1, S2; S5, S6, S7) commandables déterminant le montage de l'amplificateur d'opération, l'amplificateur d'opération (OP1) étant monté dans un des états de commutation des éléments de commutation (S1, S2; S4, S5, S6, S7) pendant une procédure de transmission de telle sorte que la partie de circuit (5) agisse comme un régulateur intégrateur et l'amplificateur d'opération (OP1) étant monté dans un autre état de commutation des éléments de commutation (S1, S2; S4, S5, S6, S7) de telle sorte que la partie de circuit (5) agisse comme un amplificateur soustracteur de telle sorte qu'à la fin d'une pause de transmission (t = 0), une valeur de départ ($U_{initiale}$) de la tension de commande ($U_c$) soit produite et se situe légèrement en dessous de la tension-seuil ($U_s$) de l'amplificateur de puissance (1).

2.  Système de communication selon la revendication 1,
    **caractérisé en ce**
    qu'une deuxième diode (D2) avec les mêmes paramètres est montée en série avec une première diode (D1) utilisée comme diode de détecteur.

3.  Système de communication selon la revendication 2,
    **caractérisé en ce**

    **que** la borne entre les première et deuxième diodes (D1, D2) est reliée avec l'entrée non inversante d'un deuxième amplificateur d'opération (OP2), que l'autre borne de la deuxième diode (D2) se situe à un potentiel de tension continue (UR),
    **que** la sortie du deuxième amplificateur d'opération (OP2) est reliée par l'intermédiaire du montage en série des première et deuxième résistances (R1, R2) avec ledit potentiel de tension continue (UR),
    et **que** la borne entre les deux résistances est reliée à l'entrée inversante du deuxième amplificateur d'opération (OP2).

4.  Système de communication selon l'une des revendications 1 à 3,
    **caractérisé en ce**
    **que** la tension de consigne ($U_{consigne}$) est égale à une tension de polarisation ($U_{pol}$) dans une première phase de l'augmentation de la tension de commande ($U_c$).

5.  Système de communication selon la revendication 4,
    **caractérisé en ce**
    **que** la dernière phase d'une baisse de la tension de commande ($U_c$) est déterminée par une tension de consigne ($U_{nég}$) négative.

6.  Système de communication selon l'une des revendications 4 ou 5,
    **caractérisé en ce**
    **qu'**après la première phase de l'augmentation de la tension de commande ($U_c$), la tension de consigne ($U_{consigne}$) augmente de manière linéaire, connaît ensuite un moment à tension de consigne constante ($U_{consigne}$), puis diminue ensuite de manière linéaire.

7.  Système de communication selon l'une des revendications 1 à 6,
    **caractérisé en ce**
    **que** l'amplificateur de puissance (1) présente seulement une entrée en vue de l'enregistrement du signal d'entrée à haute fréquence ($RF_{in}$) et de la tension de commande (Uc).

8.  Emetteur pour la communication utilisant des signaux selon le système de multiplexage par répartition dans le temps avec :

- un amplificateur de puissance (1) qui présente une entrée de commande prévue pour la réception d'une tension de commande ($U_c$), en vue de l'amplification d'un signal d'entrée à haute fréquence ($RF_{in}$) vers un signal de sortie ($RF_{out}$) à haute fréquence,

- un détecteur (2) prévu en vue de la délivrance d'une tension de détecteur ($U_0 + U_{réelle}$) pour la détection de la puissance du signal de sortie ($RF_{out}$) et pour la production d'une tension de détecteur ($U_0 + U_{réelle}$) qui est formée par la superposition d'une tension de repos de détecteur ($U_0$) avec une tension réelle ($U_{réelle}$),

- des moyens (4) en vue de la production d'une tension de consigne ($U_{consigne}$) qui déterminent le tracé temporel de la puissance du signal de sortie ($RF_{out}$),

   **caractérisé par**

une partie de circuit (5) en vue de la production de la tension de commande ($U_c$) à partir de la différence de la tension de consigne ($U_{consigne}$) et de la tension réelle ($U_{réelle}$) avec un amplificateur d'opération monté (OP1) et avec les éléments de commutation (S1, S2; S5, S6, S7) commandables déterminant le montage de l'amplificateur d'opération, l'amplificateur d'opération (OP1) étant monté dans un des états de commutation des éléments de commutation (S1, S2; S4, S5, S6, S7) pendant une procédure de transmission de telle sorte que la partie de circuit (5) agisse comme un régulateur intégrateur et l'amplificateur d'opération (OP1) étant monté dans un autre état de commutation des éléments de commutation (S1, S2; S4, S5, S6, S7) de telle sorte que la partie de circuit (5) agisse comme un amplificateur soustracteur de telle sorte qu'à la fin d'une pause de transmission (t = 0), une valeur de départ ($U_{initiale}$) de la tension de commande ($U_c$) soit produite et se situe légèrement en dessous de la tension-seuil (Us) de l'amplificateur de puissance (1).

**9.** Circuit pour un émetteur avec la communication utilisant des signaux selon le système de multiplexage par répartition dans le temps avec :

- un amplificateur de puissance (1) qui présente une entrée de commande prévue pour la réception d'une tension de commande ($U_c$), en vue de l'amplification d'un signal d'entrée à haute fréquence ($RF_{in}$) vers un signal de sortie (RFout) à haute fréquence,

- un détecteur (2) prévu en vue de la délivrance d'une tension de détecteur ($U_0 + U_{réelle}$) pour la détection de la puissance du signal de sortie ($RF_{out}$) et pour la production d'une tension de détecteur ($U_0 + U_{réelle}$) qui est formée par la superposition d'une tension de repos de détec-

---

teur ($U_0$) avec une tension réelle ($U_{réelle}$),

- des moyens (4) en vue de la production d'une tension de consigne ($U_{consigne}$) qui déterminent le tracé temporel de la puissance du signal de sortie ($RF_{out}$),

   **caractérisé par**

une partie de circuit (5) en vue de la production de la tension de commande ($U_c$) à partir de la différence de la tension de consigne ($U_{consigne}$) et de la tension réelle ($U_{réelle}$) avec un amplificateur d'opération monté (OP1) et avec les éléments de commutation (S1, S2; S5, S6, S7) commandables déterminant le montage de l'amplificateur d'opération, l'amplificateur d'opération (OP1) étant monté dans un des états de commutation des éléments de commutation (S1, S2; S4, S5, S6, S7) pendant une procédure de transmission de telle sorte que la partie de circuit (5) agisse comme un régulateur intégrateur et l'amplificateur d'opération (OP1) étant monté dans un autre état de commutation des éléments de commutation (S1, S2; S4, S5, S6, S7) de telle sorte que la partie de circuit (5) agisse comme un amplificateur soustracteur de telle sorte qu'à la fin d'une pause de transmission (t = 0), une valeur de départ ($U_{initiale}$) de la tension de commande ($U_c$) soit produite et se situe légèrement en dessous de la tension-seuil ($U_s$) de l'amplificateur de puissance (1).

FIG. 1

FIG.2

FIG. 3

FIG. 4

FIG. 5

FIG. 6

FIG. 7a

FIG. 7b